# EUROPÄISCHE PATENTSCHRIFT

(11) **EP 0 571 330 B1**
(45) Veröffentlichungstag und Bekanntmachung des Hinweises auf die Patenterteilung: **07.04.1999**
(21) Anmeldenummer: 93810358.7
(22) Anmeldetag: 14.05.1993
(51) Int. Cl.: G03F 7/004

(54) **Hochauflösender I-Linien Photoresist mit höherer Empfindlichkeit**
High-resolution photoresist with enhanced sensitivity for I-line exposure
Photoréserve à haute résolution et à sensibilité augmentée pour l'exposition avec des lampes émettant en lignes I

(30) Priorität: 22.05.1992 CH 1656/92; 29.10.1992 CH 3368/92
(43) Veröffentlichungstag der Anmeldung: 24.11.1993
(73) Patentinhaber: Ciba Specialty Chemicals Holding Inc., 4057 Basel (CH); OCG Microelectronic Materials Inc., West Paterson New Jersey 07424 (US)
(72) Erfinder: Münzel, Norbert, Dr., W-7843 Heitersheim (DE); Schulz, Reinhard, Dr., W-7813 Staufen-Wettelbrunn (DE); Holzwarth, Heinz, W-7812 Bad Krozingen (DE); Ilg, Stephan, CH-4303 Giebenach (CH)
(74) Vertreter: Roueche, Armand

(56) Entgegenhaltungen:
- EP-A- 0 241 423
- EP-A- 0 361 906

## Beschreibung

Die vorliegende Erfindung betrifft die Verwendung von bestimmten Oximsulfonatverbindungen, d. h. von Verbindungen mit dem Strukturelement 〉C = N-O-SO₂-, als strahlungsempfindlicher Säurespender in einem chemisch verstärkten, alkalisch entwickelbaren Photoresist, entsprechende positiv und negativ arbeitende Photoresists und ein Verfahren zur Herstellung von Abbildungen mit Hilfe derartiger Resists.

Unter einem chemisch verstärkten Photoresist versteht man eine Resistzusammensetzung, deren strahlungsempfindliche Komponente bei Bestrahlung lediglich die Menge Säure bereitstellt, die erforderlich ist, um eine chemische Reaktion mindestens einer säurelabilen Komponente des Resists zu katalysieren, aufgrund derer sich erst die endgültigen Löslichkeitsunterschiede zwischen bestrahlten und nicht bestrahlten Bereichen des Photoresists herausbilden.

Aus der EP-A-0 139 609 (=US-A-4,540,598) sind Industrielackzusammensetzungen auf Basis einer grossen Zahl strahlungsempfindlicher Oximsulfonate und üblicher säurehärtbarer Harze bekannt. Diese werden zur Härtung zunächst mit aktinischer Strahlung belichtet, insbesondere mit Strahlung von 250 bis 400 Nanometern Wellenlänge. Hierbei setzen die Oximsulfonate Säure frei, so dass eine thermische Härtung, bei der das Material auch in üblichen Lösungsmitteln unlöslich wird, bei relativ niedrigen Temperaturen ablaufen kann. Über eine bildmässige Belichtung entsprechender Beschichtungen oder über damit zusammenhängende Probleme sowie über die Abbildungseigenschaften der vielen von der Lehre dieses Dokuments generisch umfassten Zusammensetzungen geht nichts hervor.

Konventionelle Positivphotoresistzusammensetzungen auf Basis von Oximsulfonaten und alkalilöslichen Bindemitteln, z. B. Kresol-Novolaken oder Hydroxymethacrylat-Acrylsäure-Copolymeren, sind ebenfalls bekannt und in der EP-A-0 241 423 beschrieben. Strahlung von 200 bis 600 Nanometern Wellenlänge kann nach diesem Dokument zur Belichtung der Resists verwendet werden. Die genannten Photoresists haben jedoch den Nachteil, dass Auflösung und Empfindlichkeit gleichzeitig nie ganz befriedigen können. Insbesondere gilt dies bei Belichtung mit Strahlung im Bereich der Quecksilber-I-Linie, die eine Wellenlänge von 365 Nanometern aufweist und gerne zur bildmässigen Belichtung von Resistbeschichtungen eingesetzt wird, weil mit Quecksilbermittel- und -hochdrucklampen preiswerte Strahlungsquellen zur Verfügung stehen, um Strahlung dieser Wellenlängen mit guter Intensistät erzeugen zu können.

In dem Aufsatz "Photochemistry of Imino Sulfonate Compounds and Their Application to Chemically Amplified Resists" von Masamitsu Shirai und Masahiro Tsunooka; Journal of Photopolymer Science and Technology, Vol. 3(3), 1990, S. 301-304, sind weiterhin schon chemisch verstärkte Photoresistzusammensetzungen auf Basis von Oximsulfonaten als Säurespender und Poly(p-tert.-butyloxycarbonyloxystyrol) als säurelabiler Komponente beschrieben. Die Styrolkomponente zersetzt sich, katalysiert von der vom Säurespender unter Bestrahlung freigesetzten Säure, wobei sich Poly(p-hydroxystyrol) bildet. Dies führt dazu, dass die bestrahlten Bereiche in alkalischen Entwicklern löslich werden, so dass positive Abbildungen mit solchen Entwicklern erhalten werden können. Die beschriebenen Oximsulfonate zeigen im UV/VIS-Spektrum ein Absorptionsmaximum bei ca. 250 Nanometern, aber nur noch geringe Absorption für Strahlung von 313 und mehr Nanometern Wellenlänge. Entsprechend wurde nur eine geringe Empfindlichkeit der Zusammensetzungen für Strahlung von 313 Nanometern Wellenlänge festgestellt.

Aus der EP-A-0 361 906 sind allgemein Oximsulfonate als strahlungs-empfindliche Säurespender für den "deep-UV"- Bereich bekannt. Im Speziellen wird o-p-Toluene-sulfonyl-α-hydroxyiminobenzyl cyanid verwendet, das im Bereich von 340 bis 390 nm unbrauchbar ist.

Es ist die Aufgabe der vorliegenden Erfindung, Photoresistzusammensetzungen zur Verfügung zu stellen, die hervorragendes Auflösungsvermögen gepaart mit ausgezeichneter Empfindlichkeit zeigen. Die genannten Eigenschaften sollen dabei speziell bei Verwendung von Strahlung aus dem Bereich der Quecksilber-I-Linie auftreten, die eine Wellenlänge von etwa 365 Nanometern hat.

Überraschend lässt sich diese Aufgabe lösen durch die Verwendung der hinsichtlich ihres chromophoren Molekülteils speziell ausgewählten Oximsulfonate mit der unten angeführten Formel 1 als Säurespender in wässrig-alkalisch entwickelbaren, chemisch verstärkten Photoresistzusammensetzungen. Dies trifft sowohl für entsprechende negativ als auch für positiv arbeitende Photoresists zu, die eine säurelabile Komponente enthalten, die eine säurekatalysierte chemische Reaktion eingeht, die die Löslichkeit der Zusammensetzungen in wässrig-alkalischen Entwicklern verändert.

Die vorliegende Erfindung betrifft daher die Verwendung von Oximsulfonatverbindungen der Formel 1 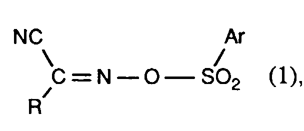 worin
R Naphthyl, 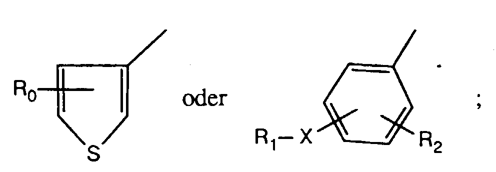 Ar eine unsubstituierte Arylgruppe oder eine Arylgruppe darstellt, die einen oder mehrere Substituenten, ausgewählt aus Nitro-, Chlor-, Brom-, Hydroxyl-, C₁-C₄-Alkyl-, C₁-C₄-Perfluoralkyl-, C₁-C₄-Alkyloxy- und säurespaltbaren Substituenten, aufweist;
R₀ entweder eine R₁-X-Gruppe oder R₂;
X ein Sauerstoff- oder Schwefelatom;
R₁ Wasserstoff, C₁-C₄-Alkyl oder eine unsubstituierte oder eine einen Substituenten, ausgewählt aus Chlor-, Brom-, C₁-C₄-Alkyl-, C₁-C₄-Alkyloxysubstituenten, aufweisende Phenylgruppe und
R₂ Wasserstoff, C₁-C₄-Alkyl oder einen säurespaltbaren Substituenten bedeuten, als strahlungsempfindlicher Säurespender in einem chemisch verstärkten alkalisch entwickelbaren Photoresist für Strahlung einer Wellenlänge von 340 bis 390 Nanometern.

Die Erfindung betrifft weiterhin chemisch verstärkte, alkalisch entwickelbare Photoresists für Strahlung einer Wellenlänge von 340 bis 390 Nanometern Wellenlänge auf Basis von Oximsulfonaten als strahlungsempfindlichem Säurespender, die als Oximsulfonate eine Verbindung der Formel 1 in der oben schon angeführten Bedeutung enthalten.

Diese Resists umfassen chemisch verstärkte, alkalisch entwickelbare und positiv arbeitende Photoresists für Strahlung einer Wellenlänge von 340 bis 390 Nanometern auf Basis von Oximsulfonaten als strahlungsempfindlichem Säurespender, die als Oximsulfonat eine Verbindung der oben erwähnten Formel 1 enthalten, worin Ar, X, R, R₀, R₁ und R₂ ebenfalls die oben angegebenen Bedeutung haben.

Eine weitere Ausführungsform stellen chemisch verstärkte, alkalisch entwickelbare und negativ arbeitende Photoresists für Strahlung einer Wellenlänge von 340 bis 390 Nanometern auf Basis von Oximsulfonaten als strahlungsempfindlichem Säurespender dar, die als Oximsulfonat ebenfalls Verbindung der bereits erwähnten Formel 1 enthalten, worin R, R₀ und X die oben schon angegebene Bedeutung haben und Ar eine unsubstituierte Arylgruppe oder eine Arylgruppe darstellt, die einen oder mehrere Nitro-, Chlor-, Brom-, Hydroxyl-, C₁-C₄-Alkyl-, C₁-C₄-Perfluoralkyl- oder Methoxy-, Ethoxy-, n-Propyloxy- oder n-Butyloxy- Substituenten aufweist; R₁ Wasserstoff, Methyl, Ethyl, n-Propyl, n-Butyl oder eine unsubstituierte oder eine einen Substituenten, ausgewählt aus Chlor-, Brom-, C₁-C₄-Alkyl-, Methoxy, Ethoxy, n-Propyloxy- oder n-Butyloxy substituenten, aufweisende Phenylgruppe und R₂ Wasserstoff, C₁-C₄-Alkyl-Substituenten bedeuten.

Beide Ausführungsformen erfindungsgemässer Photoresists können ohne weiteres Strukturelemente mit Abmessungen im Submikronbereich auflösen, z. B. Strukturen mit Abmessungen bis hinunter zu 0,3 µm, wenn zur Belichtung Strahlung von ca. 340 bis 390 Nanometern Wellenlänge eingesetzt wird. Die nach der Entwicklung auf dem Substrat verbleibenden Resiststrukturen weisen zudem eine sehr gute Kantensteilheit auf. Die Resists zeigen weiterhin eine überragende lithographische Empfindlichkeit für die genannte Strahlung. Besonders dies war nicht zu erwarten, weil die als Säurespender ausgewählten Oximsulfonate Strahlung dieser Wellenlänge nur noch äusserst schwach absorbieren. Die erfindungsgemässen Photoresists sind daher Tief-UV-Resists in den lithographischen Eigenschaften ebenbürtig, haben aber den Vorteil, dass sie mit Strahlung des nahen UV-Bereichs arbeiten, mit der die Belichtung technisch wesentlich einfacher zu bewerkstelligen ist.

Das Symbol "Ar" steht in Formel 1 allgemein für chemische Gruppen, die aromatische Ringe aufweisen. Diese enthalten bevorzugt 6 bis 12 Ringkohlenstoffatome. Insbesondere kann es sich bei Ar um unsubstituiertes Phenyl oder um Phenyl handeln, das einen oder mehrere Chlor-, Brom-, Hydroxyl-, C₁-C₄-Alkyl-, C₁-C₄-Perfluoralkyl-, C₁-C₄-Alkyloxy-oder säurespaltbare Substituenten aufweist, um unsubstituiertes oder entsprechend dem Phenyl substituiertes Naphthyl oder um unsubstituierte oder entsprechend substituierte Gruppen des Typs 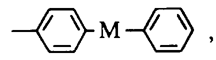 wobei M entweder eine direkte Einfachbindung oder eine der folgenden Gruppen bedeuten kann: -S-; -O-; -SO-; -SO₂-; -CO-; -C(R₅)(R₆)-, wobei R₅ Wasserstoff, Methyl oder Aryl sowie R₆ Wasserstoff oder Methyl darstellen können. C₁-C₄-Alkyl-, C₁-C₄-Perfluoralkyl-, C₁-C₄-Alkyloxy- können dabei eine der nachstehend für R₁ und R₂ angegebenen Bedeutungen haben.

In der Bedeutung C₁-C₄-Alkyl können R₁ und R₂ unabhängig voneinander insbesondere Methyl, Ethyl, n-Propyl, i-Propyl, n-Butyl-, i-Butyl, sec-Butyl, tert.-Butyl, in der Bedeutung C₁-C₄-Perfluoralkyl insbesondere die von den genannten Alkylresten abgeleiteten vollständig fluorierten Reste und in der Bedeutung C₁-C₄-Alkyloxy insbesondere Methoxy, Ethoxy, n-Propoxy, i-Propoxy, n-Butoxy-, i-Butoxy, sec-Butoxy, tert.-Butoxy sein.

Die Verbindungen der Formel 1, die säurespaltbare Gruppen aufweisen, können als Säurespender nur für positiv arbeitende Photoresists verwendet werden. Als geeignete säurespaltbare Substituenten kommen vor allem Gruppen der nachfolgenden Formeln (2) bis (6) in Frage:
-O-R₇ (2), worin R₇ einen Kohlenwasserstoffrest, z. B. einen Aralkyl- oder einen C₁-C₄-Alkylrest, insbesondere Benzyl und tert.-Butyl bedeutet; 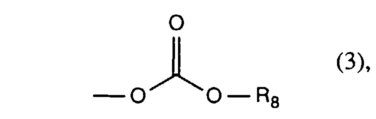 worin R₈ einen Kohlenwasserstoffrest, z. B. einen Aralkyl- oder einen C₁-C₄-Alkylrest, insbesondere Benzyl und C₁-C₄-Alkyl, wie Ethyl oder tert.-Butyl, bedeutet; 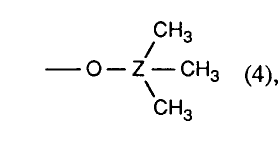 worin Z entweder Silicium oder Kohlenstoff bedeutet; 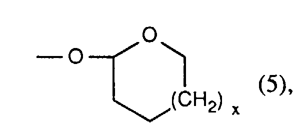 worin x entweder 0 oder 1 ist; oder 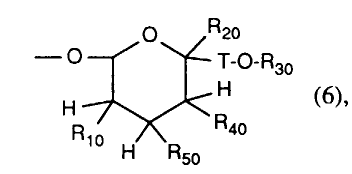 worin R₁₀ Wasserstoff, Halogen, Alkyl, Cycloalkyl, Aryl, Alkoxy oder Aryloxy, R₂₀ Wasserstoff, Alkyl, Cycloalkyl or Aryl, R₃₀ einen gesättigten oder ungesättigten Kohlenwasserstoffrest, R₄₀ und R₅₀ unabhängig voneinander Wasserstoff, Halogen, Alkyl, Alkoxy oder Aryloxy, und T eine direkte Einzelbindung oder eine Methylen- oder Ethylenbrücke bedeutet. Schutzgruppen der Formel 6 sind in der EP-A-0 475 903 beschrieben. Die dort genannten Bevorzugungen für die Reste R₁₀, R₂₀, R₃₀, R₄₀, R₅₀ und T treffen auch im vorliegenden Fall zu.

Verbindungen der Formel 1 mit den genannten säurespaltbaren Gruppen können nach bekannten Methoden aus den an der entsprechenden Stelle Hydroxylsubstituenten aufweisenden Verbindungen hergestellt werden.

Bevorzugte Photoresists gemäss der Erfindung enthalten Oximsulfonatverbindungen der Formel 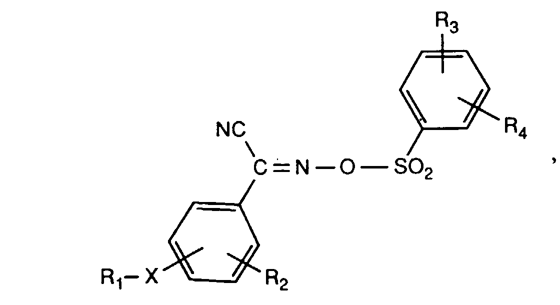 worin
X ein Sauerstoff- oder Schwefelatom, R₁ Wasserstoff, Phenyl oder C₁-C₄-Alkyl, R₂ und
R₃ unabhängig voneinander Wasserstoff oder C₁-C₄-Alkyl und R₄ Wasserstoff, Chlor, Brom, Hydroxyl, Trifluormethyl oder C₁-C₄-Alkyl bedeuten.

Besonders bevorzugt werden hiervon die Photoresists, worin X ein Sauerstoffatom bedeutet, R₁ einen C₁-C₄-Alkylrest, insbesondere Methyl oder Ethyl, oder Phenyl und R₂, R₃ und R₄ unabhängig voneinander Wasserstoff, Chlor oder Methyl bedeuten. Ganz besonders bevorzugt ist es, wenn R₂ und R₃ Wasserstoffatome sind und R₄ eine Methylgruppe ist.

Weiterhin bevorzugt sind Photoresists auf Basis von Verbindungen der Formel 1 als Säuregenerator, worin R 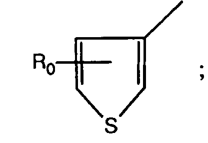 Ar eine Arylgruppe der Formel 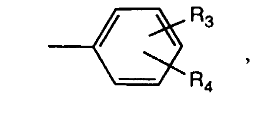 worin R₃ und R₄ die oben schon erwähnte Bedeutung haben und R₀ Wasserstoff bedeutet.

Wie schon erwähnt, kann die Differenzierung der Löslichkeit von belichteten und unbelichteten Partien, die aufgrund der säurekatalysierten Reaktion des Resistsmaterials während oder nach der Bestrahlung des Resists auftritt, von zweierlei Art sein, je nachdem welche weiteren Bestandteile der Resist enthält. Enthalten die erfindungsgemässen Zusammensetzungen Komponenten, die die Löslichkeit der Zusammensetzung im Entwickler erhöhen, arbeitet der Resist mit positiver Charakteristik. Senken diese Komponenten dagegen die Löslichkeit der Zusammensetzung, arbeitet der Resist negativ.

Eine negative Charakterisik bewirkende säurelabile Komponenten sind insbesondere Verbindungen, die katalysiert von (der bei Bestrahlung der Verbindung 1 gebildeten) Säure, mit sich selbst oder einer beziehungsweise mehreren weiteren Komponenten in der Zusammensetzung eine Vernetzungsreaktion eingehen können. Verbindungen dieser Art sind z. B. die bekannten säurehärtbaren Harze, wie beispielsweise Acryl-, Polyester-, Alkyd-, Melamin-, Harnstoff-, Epoxid- und Phenolharze oder Gemische davon. Sehr gur geeignet sind Aminoharze, Phenolharze und Epoxidharze. Säurehärtbare Harze wie diese sind allgemein geläufig und z. B. in Ullmann's Encyclopädie der technischen Chemie, Aufl. 4, Bd. 15(1978), S. 613 - 628 beschrieben. Sie sollen im allgemeinen in einer Konzentration von 2 bis 40, bevorzugt 5 bis 30 Gewichtsprozent, bezogen auf den Gesamtfeststoffgehalt der negativ arbeitenden Zusammensetzung vorhanden sein.

Ganz besonders bevorzugt als säurehärtbare Harze sind Aminoharze, wie z. B. unveretherte oder veretherte Melamin-, Harnstoff-, Guanidin- oder Biuretharze, insbesondere methylierte Melaminharze oder butylierte Melaminharze, entsprechende Gycolurile und Urone. Unter Harze werden hierbei sowohl die üblichen technischen Gemische, die im allgemeinen auch Oligomere und enthalten, als auch die reinen und hochreinen definierten Verbindungen verstanden. N-Methoxymethylmelamin (Formel 7) sowie Tetramethoxymethylglucoril (Formel 8) und N,N'-Dimethoxymethyluron (Formel 9) sind die am meisten bevorzugten säurehärtbaren Harze

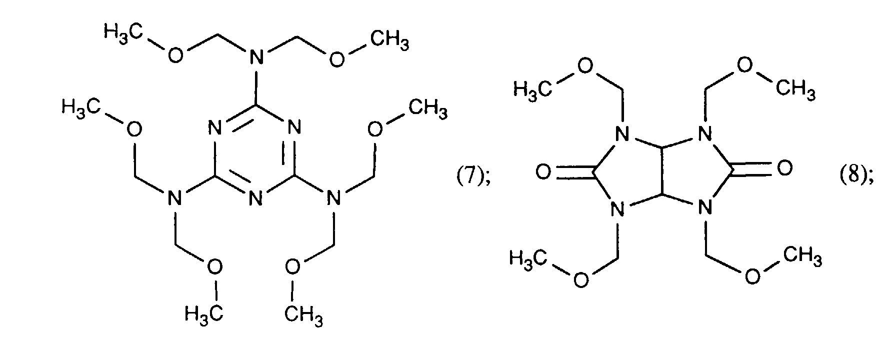

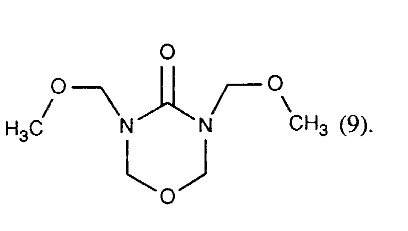

Die Konzentration der Verbindung mit Formel 1 beträgt in Negativresists im allgemeinen 0,1 bis 30, bevorzugt bis 20 Gewichtsprozent, ebenfalls bezogen auf den Gesamtfeststoff der Zusammensetzungen. Ganz besonders bevorzugt sind 1 bis 15 Gewichtsprozent.

Gegebenenfalls können die negativ arbeitenden Zusammensetzungen noch zusätzlich ein filmbildendes polymeres Bindemittel enthalten. Bevorzugt handelt es sich hierbei um ein alkalilösliches Phenolharz. Gut hierfür geeignet sind z. B. Novolake, abgeleitet von einem Aldehyd, beispielsweise Acetaldehyd oder Furfuraldehyd, insbesondere jedoch von Formaldehyd, und einem Phenol, z. B. unsubstituiertem Phenol, ein- oder zweifach chlorsubstituiertem Phenol, wie p-Chlorphenol, ein- oder zweifach mit C₁-C₉-Alkyl substituiertem Phenol, wie o-, m- oder p-Kresol, den verschiedenen Xylenolen, p-tert.-Butylphenol, p-Nonylphenol, p-Phenylphenol, Resorcin, Bis-(4-hydroxyphenyl)-methan oder 2,2-Bis-(4-hydroxyphenyl)-propan. Weiterhin sind geeignet Homo- und Copolymere auf Basis ethylenisch ungesättigter Phenole, z. B. Homopolymere von vinyl- und 1-propenylsubstituierten Phenolen, wie p-Vinylphenol oder p-(1-Propenyl)phenol oder Copolymere dieser Phenole mit einem oder mehreren ethylenisch ungesättigten Materialien, beispielsweise Styrolen. Die Menge des Bindemittels sollte im allgemeinen zwischen 30 und 95 Gewichtsprozent oder bevorzugt zwischen 40 und 80 Gewichtsprozent liegen.

Somit umfasst die Erfindung als eine spezielle Ausführungsform negativ arbeitende, alkalisch entwickelbare Photoresists für eine Arbeitsstrahlung von 340 bis 390 Nanometern Wellenlänge, enthaltend ein Oximsulfonat der Formel 1 in der oben beschriebenen Bedeutung, das jedoch keine säurespaltbaren Gruppen aufweist, ein alkalilösliches Phenolharz als Bindemittel und eine Komponente, die säurekatalysiert eine Vernetzungsreaktion mit sich selbst und/oder dem Bindemittel eingeht.

Eine besonders bevorzugte Form dieser Negativresists enthält 1 bis 15 Gewichtsprozent Oximsulfonat, 40 bis 80 Gewichtsprozent eines Phenolharzes als Bindemittel, z. B. eines der oben genannten, sowie 5 bis 30 Gewichtsprozent eines Melaminharzes als Vernetzungsmittel, wobei die sich die Prozentangaben auf den Feststoffgehalt der Zusammensetzung beziehen. Mit Novolak oder insbesondere mit Polyvinylphenol als Bindemittel ergibt sich ein Negativresist mit besonders guten Eigenschaften.

Neben den Oximsulfonaten der Formel 1, die eine oder mehrere säurespaltbaren Substituenten aufweisen, erzeugen auch monomere oder polymere Verbindungen, die alkaliunlöslich sind, aber in Gegenwart von Säure in einer Weise gespalten werden oder sich intramolekular umlagern können, dass Reaktionsprodukte verbleiben, die in einem üblichen alkalischen Entwickler löslich sind und/oder die Löslichkeit eines sonst alkaliunlöslichen und säureresistenten zusätzlichen Bindemittels im Entwickler bewirken, eine positiv arbeitende Charakteristik bei erfindungsgemässen Photoresistzusammensetzungen. Stoffe dieser Art werden nachfolgend auch als Lösungsinhibitoren bezeichnet.

Die Erfindung umfasst daher als eine weitere spezielle Ausführungsform positiv arbeitende alkalisch entwickelbare Photoresists für eine Arbeitsstrahlung von 340 bis 390 Nanometern Wellenlänge, enthaltend eine Verbindung der Formel 1, die jedoch keine säurespaltbaren Substituenten aufweist, und mindestens eine Verbindung, die das Lösen der Zusammensetzung in einem alkalischen Entwickler im wesentlichen verhindert, die aber in Gegenwart von Säure in einer Weise gespalten werden kann, dass Reaktionsprodukte verbleiben, die in dem Entwickler löslich sind und/oder die Lösung eines sonst im Entwickler praktisch unlöslichen, säureresistenten zusätzlich enthaltenen Bindemittels im Entwickler bewirken.

Als Lösungsinhibitoren können hierbei monomere und polymere organische Verbindungen mit funktionellen Gruppen eingesetzt werden, die im alkalischen an sich löslich wären, z. B. mit aromatischen Hydroxylgruppen, Carbonsäuregruppen, sekundären Aminogruppen sowie Keto- oder Aldehydgruppen, jedoch durch Umsetzung mit einer geeigneten Verbindung chemisch so verändert wurden, dass sie in wässrigem Alkali unlöslich sind, und wobei die bei der genannten Umsetzung gebildeten Schutzgruppen säurekatalysiert wieder so gespalten werden können, dass die funktionellen Gruppen in ihrer ursprünglichen Form zurückerhalten werden.

Zum Schutz von Hydroxylgruppen, Carbonsäuregruppen oder sekundären Aminogruppen eignen sich zum Beispiel Dihydrofuran oder 3,4-Dihydropyran und deren Derivate, Benzylhalogenide, Alkylhalogenide, Halogenessigsäure, Halogenessigsäureester, Chlorkohlensäureester, Alkylsulfonylhalogenide, aromatische Sulfonylhalogenide, Dialkyldicarbonate oder Trialkylsilylhalogenide, wobei die Umsetzungen in bekannter Weise durchgeführt werden können. Zum Schutz von Keto- und Aldehydgruppen ist eine übliche Umwandlung in Ketale und Acetale geeignet.

Besonders bevorzugt sind Verbindungen mit blockierten aromatischen Hydroxylgruppen, wobei es sich ebenfalls sowohl um monomere als auch um polymere Verbindungen handeln kann. Die monomeren aromatischen Verbindungen weisen bevorzugt einen oder mehr, insbesondere zwei bis sechs aromatische Kerne mit beispielsweise 6 bis 14, insbesondere mit 6 Ringkohlenstoffatomen auf. Die aromatischen Kerne können selbstverständlich ausser den blockierten Hydroxylgruppen gegebenenfalls weitere Substituenten aufweisen, insbesondere C₁-C₄-Alkyl, C₁-C₄-Alkoxy oder Halogen. Besonders bevorzugt als monomere Lösungsinhibitoren sind Bisphenyltypen, d. h. Verbindungen der Formel 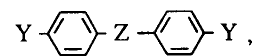 wobei Y jeweils eine Gruppe der Formel (2) bis (6) bedeutet und Z entweder eine direkte Einfachbindung oder eine der folgenden Gruppen bedeuten kann: -S-; -O-; -SO-; -SO₂-; -CO-; -C(R₅)(R₆)-, wobei R₅ Wasserstoff, Methyl oder Aryl sowie R₆ Wasserstoff oder Methyl darstellen können. Besonders bevorzugte zweiwertige Reste -C(R₅)(R₆)- sind -CH₂-; -C(CH₃)₂- und -C(CH₃)(Ph)-. Die bevorzugten polymeren Lösungsinhibitoren leiten sich von üblichen Phenolharzen ab, so z. B. von Polyvinylphenolen, deren Hydroxylgruppen ebenfalls in einer Form blockiert sind, wie es den oben erwähnten Formeln (2) bis (6) entspricht. Lösungsinhibitoren mit Schutzgruppen der genannten Art sind bereits bekannt. Inhibitoren mit Gruppen der Formel 3 sind z. B. von Dennis R. McKean, Scott A. McDonald, Nicholas J. Clecak und C. Grant Willson in "Novolac based deep-UV resists", SPIE Vol. 920 Advances in Resist Technology and Processing V (1988), S. 60-63, oder von Masamitsu Shirai und Masahiro Tsunooka in "Photochemistry of Imino Sulfonate Compounds and their Application to Chemically Amplified Resists", Journal of Photopolymer Science and Technology, Vol. 3(3), 1990, S. 301-304, beschrieben. Sie können nach üblichen bekannten Methoden erhalten werden, z. B. gemäss J. M. J. Frechet, E. Eichler, H. Ito und C. G. Willson, Polymer 24 (1983), S. 995. Lösungsinhibitoren mit Substituenten der Formel (4) sind in der EP-A-0 329 610, Inhibitoren mit Schutzgruppen der Formel (5) z. B. von N. Hayashi, S. M. A. Hesp, T. Ueno, M. Toriumi, T. Iwayanagi und S. Nonogaki in Polym. Mat. Sci. Eng. 61(1989), S. 417-421, und aromatische Verbindungen mit Gruppen der Formel (6) in der EP-A-0 475 903 näher beschrieben. Die Schutzgruppen der Formeln 4 und 5 können z. B. in bekannter Weise durch Addition von 3,4-Dihydropyranen oder -furanen unter sauren Bedingungen erhalten werden.

Bei Positivresists der genannten Art kann ein filmbildender, polymerer Lösungsinhibitor entweder das alleinige Bindemittel des Photoresists darstellen oder im Gemisch mit einem säureinerten Bindemittel und gegebenenfalls einem monomeren Lösungsinhibitor eingesetzt werden.

Beispiele für säureinerte Bindemittel sind Novolake, insbesondere auf Basis von o-, m-oder p-Kresol und Formaldehyd, ferner Poly(p-hydroxystyrol), Poly(p-hydroxy-α-methylstyrol) und Copolymerisate aus p-Hydroxystyrol, p-Hydroxy-α-methylstyrol und Acetoxystyrol.

Beispiele für polymere Lösungsinhibitoren sind Novolake, insbesondere auf Basis von o-, m- oder p-Kresol und Formaldehyd, Poly(p-hydroxystyrol), Poly(p-hydroxy-α-methylstyrol), Copolymerisate aus p-Hydroxystyrol oder p-Hydroxy-α-methylstyrol und Acetoxystyrol oder Acrylsäure und/oder Methacrylsäure sowie (Meth)acrylsäureestern, die mit Dihydrofuran, 3,4-Dihydropyran, Benzylhalogeniden, Alkylhalogeniden, Halogenessigsäure, Halogenessigsäureestern, Chlorkohlensäureestern, Alkylsulfonylhalogeniden, aromatischen Sulfonylhalogeniden, Dialkyldicarbonat oder Trialkylsilylhalogeniden in bekannter Weise umgesetzt sind. Ebenfalls geeignet sind Polymerisate von p-(2-Tetrahydropyranyl)-oxystyrol oder p-(tert.-Butyloxycarbonyl)-oxystyrol mit (Meth)acrylsäure, (Meth)acrylsäureestern und/oder p-Acetoxystyrol sowie Polymerisate aus p-Hydroxystyrol und/oder p-(2-Tetrahydropyranyl)-oxystyrol mit 3-Hydroxybenzyl(meth)acrylaten, die gegebenenfalls durch Umsetzung mit einer der oben angeführten Verbindungen zusätzlich geschützt sein können.

Eine spezielle Ausführungsform der erfindungsgemässen Positivresists enthält 75 bis 99,5 Gewichtsprozent eines filmbildenden Polymeren, der säurekatalysiert abspaltbare Schutzgruppen aufweist, und 0,5 bis 25 Gewichtsprozent Oximsulfonate der Formel 1, wobei die Prozentangaben auf den Feststoffgehalt der Zusammensetzungen bezogen sind. Bevorzugt sind hierbei Zusammensetzungen, enthaltend 80 bis 99 Gewichtsprozent des genannten Polymeren und 1 bis 20 Gewichtsprozent Oximsulfonat.

Eine andere Ausführungsform stellt ein Positivresist dar, der 40 bis 90 Gewichtsprozent eines säureinerten filmbildenden Polymeren als Bindemittel, 5 bis 40 Gewichtsprozent einer monomeren oder polymeren Verbindung, die säurekatalysiert abspaltbare Schutzgruppen aufweist, und 0,5 bis 25 Gewichtsprozent Oximsulfonate der Formel 1 enthält, wobei die Prozentangaben auf den Feststoffgehalt der Zusammensetzungen bezogen sind. Hiervon sind Zusammensetzungen, enthaltend 50 bis 85 Gewichtsprozent des säureinerten Bindemittels, 10 bis 30 Gewichtsprozent des monomeren oder polymeren Lösungsinhibitors und 1 bis 15 Gewichtsprozent Oximsulfonate bevorzugt.

Eine weitere spezielle Ausführungsform der Erfindung stellt schliesslich ein Positivresist dar, enthaltend eine Verbindung der Formel 1, die mindestens einen säurespaltbaren Substituenten aufweist und ein in einem alkalischen Entwickler praktisch unlösliches Bindemittel, das in Gegenwart der Reaktionsprodukte, die bei Säurespaltung der genannten säurespaltbaren Substituenten entstehen, im Entwickler löslich wird. Hierbei beträgt die Menge der genannten Oximsulfonatverbindung im allgemeinen 5 bis 50 Gewichtsprozent, bezogen auf den Feststoffgehalt der Zusammensetzung.

Sowohl die negativ als auch die positiv arbeitenden Photoresistzusammensetzungen können ausser den genannten Bestandteilen noch einen oder mehrere der für Photoresists üblichen Zusatzstoffe in den für den Fachmann gebräuchlichen Mengen enthalten, z. B. Verlaufsmittel, Netzmittel, Haftmittel, Thixotropiemittel, Farbstoffe, Pigmente Füllstoffe, Löslichkeitsbeschleuniger und so fort. Stoffe, die die Zusammensetzungen für die Arbeitsstrahlung im Bereich der Quecksilber-I-Linie zusätzlich sensibilisieren, sollten allerdings nicht zugesetzt werden, da dies in aller Regel zu einer Verschlechterung der Auflösung des Resists führen würde.

Zur Applikation müssen die Zusammensetzungen im allgemeinen noch ein Lösungsmittel enthalten. Beispiele für geeignete Lösungsmittel sind Ethylacetat, 3-Methoxymethylproprionat, Ethylpyruvat, 2-Heptanon, Diethylglycoldimethylether, Cyclopentanon, Cyclohexanon, γ-Butyrolacton, Ethylmethylketon, 2-Ethoxyethanol, 2-Ethoxyethylacetat und insbesondere 1-Methoxy-2-propylacetat. Als Lösungsmittel kann auch ein Gemisch vorliegen, z. B. aus zwei oder mehreren der vorgenannten Lösungsmittel. Die Wahl des Lösungsmittels und die Konzentration richten sich z. B. nach der Art der Zusammensetzung und nach dem Beschichtungsverfahren.

Die Lösung wird mittels bekannten Beschichtungsverfahren auf ein Substrat gleichförmig aufgebracht, z.B. durch Schleudern, Tauchen, Rakelbeschichtung, Vorhanggiessverfahren, Aufpinseln, Sprühen und Reverse Rollbeschichtung. Es ist auch möglich, die lichtempfindliche Schicht auf einen temporären, flexiblen Träger zu bringen, und dann durch Schichtübertragung (Laminierung) das endgültige Substrat zu beschichten.

Die Auftragsmenge (Schichtdicke) und Art des Substrates (Schichtträger) sind abhängig vom gewünschten Applikationsgebiet. Der Schichtdickenbereich kann prinzipiell Werte von ca. 0,1 µm bis mehr als 100 µm umfassen.

Mögliche Einsatzgebiete der erfindungsgemässen Zusammensetzung sind die Verwendung als Photoresists für die Elektronik, die Herstellung von Druckplatten, wie Offsetdruckplatten oder Siebdruckformen, der Einsatz beim Formteilätzen und insbesondere der Einsatz als Mikroresist bei der Herstellung integrierter Schaltkreise. Entsprechend unterschiedlich sind die Schichtträger und Verarbeitungsbedingungen.

Beim Einsatz als Mikroresist für integrierte und hochintegrierte Schaltkreise, wie es bevorzugt ist, liegen die Schichtdicken im allgemeinen zwischen 0,1 und 10 µm, bevorzugt zwischen 0,5 und 5 µm, insbesondere zwischen 0,5 und 1,5 µm.

Die erfindungsgemässen Zusammensetzungen eignen sich hervorragend als Beschichtungsmittel für Substrate aller Art, einschliesslich Holz, Textilien, Papier, Keramik, Glas, Kunststoffe, wie Polyester, Polyethylenterephthalat, Polyolefine oder Celluloseacetat, insbesondere in Form von Filmen, insbesondere aber zur Beschichtung von Metallen, wie Ni, Fe, Zn, Mg Co oder insbesondere Cu und Al, sowie von Si , Siliciumoxiden oder -nitriden, auf denen durch bildmässiges Belichten eine Abbildung aufgebracht werden soll.

Nach dem Beschichten wird das Lösungsmittel in der Regel durch Erwärmen entfernt und es resultiert eine Schicht des Photoresists auf dem Träger. Die Trocknungstemperatur muss selbstverständlich unterhalb der Temperatur liegen, bei der bestimmte Komponenten des Resists thermisch aushärten könnten. Dies ist besonders bei den negativ arbeitenden Photoresists zu beachten. Zur Trocknung sollten die Temperaturen im allgemeinen 80 bis 130 °C nicht übersteigen.

Danach wird die Resistbeschichtung bildmässig belichtet. Diese Belichtung in einem vorbestimmten Muster mit aktinischer Strahlung beinhaltet sowohl die Belichtung durch eine Photomaske, die ein vorbestimmtes Muster enthält, beispielsweise ein Diapositiv, als auch die Belichtung mit Hilfe eines Laserstrahls, der beispielsweise computergesteuert über die Oberfläche des beschichteten Substrates bewegt wird, und auf diese Weise ein Bild erzeugt.

Erfindungsgemäss sind Strahlungsquellen geeignet, die Strahlung einer Wellenlänge von etwa 340 bis 390 oder bevorzugt von 360 bis 390 Nanometern abgeben. Ganz besonders geeignet ist Strahlung der Quecksilber-I-Linie von 365 Nanometern Wellenlänge. Als Lichtquellen kommen daher insbesondere Quecksilberdampflampen, speziell Quecksilbermittel- und -hochdrucklampen in Frage, aus deren Strahlung die Emissionslinien bei anderen Wellenlängen gegebenenfalls herausgefiltert werden. Insbesondere trifft dies für kurzwelligere Strahlung zu. Der Abstand zwischen Lampe und Werkstück kann je nach Anwendungszweck und Lampentyp bzw. -stärke variieren, z.B. zwischen 2 cm bis 150 cm. Eine geeignete Laserstrahlenquelle ist beispielsweise der Argon-Ionen-Laser, der Strahlung einer Wellenlänge von 364 und 388 Nanometern emittiert. Bei dieser Art der Belichtung ist eine Photomaske im Kontakt mit der Photopolymerschicht nicht mehr unbedingt nötig; der gesteuerte Laser-Strahl kann direkt auf die Schicht schreiben. Hierzu ist die hohe Empfindlichkeit der erfindungsgemässen Materialien sehr vorteilhaft, die hohe Schreibgeschwindigkeiten bei relativ niedrigen Intensitäten erlaubt. Bei der Belichtung zersetzt sich an den bestrahlten Partien der Beschichtung das Oximsulfonat in der Zusammensetzung unter Bildung von Sulfonsäuren.

Vor der Entwicklung ist im allgemeinen ein gewisser Zeitraum erforderlich, damit die säurelabilen Komponenten der Resistzusammensetzung reagieren können. Um diese Reaktion und damit die Ausbildung einer ausreichend stark unterschiedlichen Löslichkeit von bestrahlten und unbestrahlten Partien der Resistbeschichtung im Entwickler zu beschleunigen, wird die Beschichtung vor der Entwicklung bevorzugt erwärmt. Die Erwärmung kann auch schon während der Belichtung durchgeführt werden oder beginnen. Bevorzugt werden Temperaturen zwischen 60 und 150 °C angewandt. Die Zeitdauer richtet sich nach der Erwärmungsweise und kann vom Fachmann notfalls leicht mit einigen Routineversuchen optimiert werden. Sie liegt im allgemeinen zwischen einigen Sekunden und mehreren Minuten. Beispielsweise sind bei Verwendung einer Hotplate 10 bis 300 Sekunden, bei Verwendung eines Konvektionsofens 1 bis 30 Minuten gut geeignet.

Danach wird die Schicht entwickelt, wobei die nach der Bestrahlung im Entwickler besser löslichen Teile der Beschichtung entfernt werden. Gegebenenfalls kann leichtes Bewegen des Werkstücks, leichtes Bürsten der Beschichtung im Entwicklerbad oder Sprühentwicklung diesen Verfahrensschritt beschleunigen. Zu Entwicklung können z. B. die üblichen wässrig-alkalischen Entwickler der Resisttechnologie verwendet werden. Solche Entwickler enthalten z. B. Natrium- oder Kaliumhydroxid, die entsprechenden Carbonate, Bicarbonate, Silikate, Metasilicate, bevorzugt aber metallfreie Basen, wie Ammoniak oder Amine, z. B. Ethylamin, n-Propylamin, Diethylamin, Di-n-propylamin, Triethylamin, Methyldiethylamin, Alkanolamine, z. B. Dimethylethanolamin, Triethanolamin, quarternäre Ammoniumhydroxide, z. B. Tetramethylammoniumhydroxid oder Tetraethylammoniumhydroxid. Die Entwicklerlösungen sind im allgemeinen bis zu 0,5 N, werden aber in der Regel vor Gebrauch in geeigneter Weise verdünnt. Gut einsetzbar sind beispielsweise Lösungen einer Normalität von ca. 0,1. Die Wahl des jeweiligen Entwicklers richtet sich nach der Art des Photolacks, insbesondere nach der Natur des verwendeten Bindemittels oder der entstehenden Photolyseprodukte. Die wässrigen Entwicklerlösungen können gegebenenfalls auch kleinere Mengen an Netzmitteln und/oder organischen Lösungsmitteln enthalten. Typische organische Lösungsmittel, die den Entwicklerflüssigkeiten zugesetzt werden können, sind beispielsweise Cyclohexanon, 2-Ethoxyethanol, Toluol, Aceton, Isopropanol sowie Mischungen zweier oder mehrerer dieser Lösungsmittel. Ein typisches wässrig/organisches Entwicklungssystem basiert auf Butylcellosolve®/Wasser.

Die Erfindung betrifft daher auch ein Verfahren zur Herstellung einer Abbildung, bei der ein Substrat mit einer erfindungsgemässen Zusammensetzung beschichtet wird, die Beschichtung mit Strahlung einer Wellenlänge von 340 bis 390 Nanometern in einem gewünschten Muster bestrahlt wird und nach einer Erwärmungsphase die besser löslichen Partien der Beschichtung mit einem wässrig-alkalischen Entwickler entfernt werden.

### Beispiel 1: Herstellung von α-Hydroxyimino-4-methoxybenzylcyanid und α-(4-Toluol-sulfonyloxyimino)-4-methoxybenzylcyanid.

64,5 g Methanol, 365 g Xylol und 80 g Natriumhydroxyd (2 mol) werden zusammen mit 147 g (1 mol) 4-Methoxyphenyl-acetonitril vorgelegt. Bei 40 °C werden 125 g (1,07 mol) Isopentylnitrit innerhalb von 2 Stunden zugetropft. Das Reaktionsgemisch wird zunächst 2 Stunden bei dieser Temperatur und weitere 20 Stunden bei Raumtemperatur gerührt. Danach wird mit Wasser unter Bildung einer Emulsion verdünnt, mit Natronlauge auf pH 14 eingestellt und die organische Phase abgetrennt. Die wässrige Phase wird mit Salzsäure angesäuert und das Produkt mit Ether extrahiert. Die etherische Phase wird getrocknet und der Ether abgezogen. Nach Umkristallisation aus Toluol beträgt die Ausbeute an α-Hydroxyimino-4-methoxy-benzylcyanid 142 g, entsprechend einer Ausbeute von 80,6 % der Theorie.

Das ¹H-NMR Spektrum (Aceton-d₆) zeigt im aromatischen Bereich zwei symmetrische Multipletts bei 7,06 und 7,72 ppm (4 H), ein Singulett bei 3,87 ppm (3 H) und ein Singulett bei 12,37 ppm (1 H).

51,0 g (0,29 mol) α-Hydroxyimino-4-methoxy-benzylcyanid werden zusammen mit 44,0 g (0,43 mol) Triethylamin in 400 ml Tetrahydrofuran vorgelegt und die Lösung auf -5°C abgekühlt. Innerhalb von 2 Stunden werden 61 g (0,32 mol) 4-Toluolsulfonylchlorid (gelöst in 200 ml Tetrahydrofuran) zugetropft. Es wird 3 Stunden bei -5 °C und weitere 2 Stunden bei etwa 10 °C nachgerührt. Tetrahydrofuran wird bei 30 °C im Vakuum abgezogen und das erhaltene braune Rohprodukt (88g) mehrfach in Acetonitril umkristallisiert. Es werden 40 g, entsprechend 42% Ausbeute, rein weisser Kristalle mit einem Schmelzpunkt von 141 °C erhalten.

Im Massenspektum wird bei m/e 330 der entsprechende Molekülmassenpeak nachgewiesen. Das ¹H-NMR Spektrum zeigt Singuletts bei 2,47 ppm (3 H) und 3,88 ppm (3 H) sowie im aromatischen Bereich zwischen 6,95 und 7,95 ppm ein Multiplett (8 H). Im UV/VIS Spektrum (gemessen in THF, Schichtdicke 1,00 cm) liegt die langwelligste Bande bei λₘₐₓ= 319 Nanometern Wellenlänge (ε = 14100 1·mol⁻¹·cm⁻¹). Bei einer Wellenlänge von 365 Nanometern, wie es der Quecksilber-I-Linie entspricht, wird die Absorption ε zu etwa 230 l·mol⁻¹·cm⁻¹ bestimmt.

### Beispiel 2: Positiv arbeitender Resist auf Basis eines polymeren Lösungsinhibitors und ohne säureinertes Bindemittel.

24,7 g eines partiell mit Trimethylsilylgruppen silylierten Polyvinylphenols, das dem in Beispiel 1 der EP-A- 0 329 610 genannten silylierten Phenolharz entspricht, und 1,4 g α-(4-Toluol-sulfonyloxyimino)-4-methoxybenzylcyanid aus Beispiel 1 werden in 74,0 g 1-Methoxy-2-propylacetat geloest. Diese Photoresistlösung wird nach Feinstfiltration (0,2 µm) so auf einen Siliciumwafer aufgeschleudert, dass nach 60 Sekunden Vortrocknung bei 100 °C auf der Hotplate ein Film mit einer Schichtdicke von 1,1 µm erhalten wird. Die Belichtung erfolgt mit einer Dosis von 30 mJ/cm² bei 365 Nanometern durch eine Auflösungsmaske im Kontaktverfahren (Gerät: Canon PLA-501, Hg-Hochdrucklampe), wobei die Belichtungsenergie mit einer Photodiode bei 365 Nanometern Wellenlänge gemessen wird. Nach der Belichtung wird 60 Sekunden bei 100 °C ausgeheizt und anschliessend 60 Sekunden in wässriger 0,262 N Tetramethylammoniumhydroxid (TMAH)-Lösung entwickelt. Es werden positive Abbilder (Submikrometerstrukturen) der Auflösungsmaske erhalten.

### Beispiel 3: Positiv arbeitender Photoresist auf Basis eines monomeren Lösungsinhibitors und eines säureinerten Bindemittels.

18,2 g Polyvinylphenol (PHM-C, Hersteller: Maruzen Chemicals), 8,4 g mit tert.-Butoxy-carbonyl Gruppen geschütztes Bisphenol-A gemäss der Formel 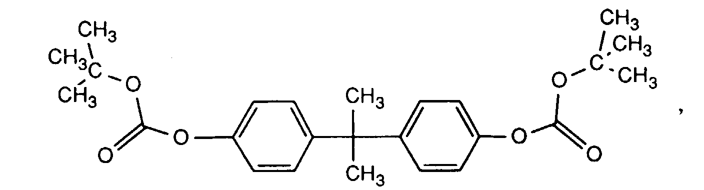 hergestellt nach der allgemein bekannten Vorschrift (z.B. J.M.J. Frechet, E. Eichler, H. Ito und C.G. Willson, Polymer, 24 (1983), 995) sowie 1,4 g des α-(4-Toluol-sulfonyloxyimino)-4-methoxybenzylcyanid werden in 72,0 g 1-Metoxy-2-propylacetat gelöst und feinstfiltriert (0,2 µm). Die Applikation der Photoresistlösung erfolgt analog Beispiel 2. Die Belichtungsdosis beträgt in diesem Fall 20 mJ/cm². Nach dem Ausheizen auf der Hot Plate (60 Sekunden bei 100 °C) und 60-sekündiger Entwicklung mit wässriger 0,131 N TMAH Lösung werden positive Abbilder der Maske erhalten. Submikrometerstrukturen waren aufgelöst.

### Beispiel 4: Negativ arbeitender Photoresist

18,2 g Polyvinylphenol (PHM-C, Hersteller: Maruzen Chemicals) werden zusammen mit 8,4 g Hexa(methoxymethyl)melamin (Cymel®303; Hersteller: Cyanamid) und 1,4 g des α-(4-Toluol-sulfonyloxyimino)-4-methoxybenzylcyanid in 72,0 g 1-Methoxy-2-propylacetat gelöst und mit einem 0,2 µm Filter feinstfiltriert. Analog zu Beispiel 2 wird die Photoresistlösung angewendet. Mit einer Belichtungsdosis von 15 mJ/cm², 60-sekündigem Ausheizen bei 115 °C auf der Hot Plate und anschliessendem Entwickeln in 0,262 N TMAH Lösung wird ein negatives Abbild der Strukturierungsmaske erhalten, wobei Submikrometerstrukturen gut aufgelöst werden. Die Profilkanten der gebildeten Strukturen sind senkrecht.

### Beispiel 5: Negativ arbeitender Photoresist

10,1 g m-Kresol-Novolak werden zusammen mit 2,6 g Hexa(methoxymethyl)melamin und 0,3 g α(4-Toluol-sulfonyloxyimino)-4-thienylcyanid der Formel 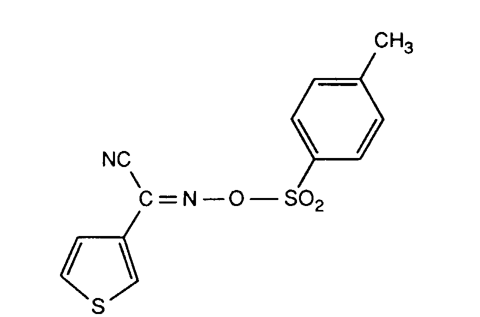 in 31,8 g Diethylenglycoldimethylether gelöst und mit einem 0,2 µm Filter feinstfiltriert. Analog zu Beispiel 2 wird die Photoresistlösung angewendet. Mit einer Belichtungsdosis von 66 mJ/cm², 60-sekündigem Ausheizen bei 110 °C auf der Hot Plate und anschliessendem Entwickeln in 0,262 N TMAH Lösung wird ein negatives Abbild der Strukturierungsmaske erhalten, wobei Submikrometerstrukturen gut aufgelöst werden. Die Profilkanten der gebildeten Strukturen sind senkrecht.

### Beispiel 6: Negativ arbeitender Photoresist

4,13 g kommerziell erhältlicher m-Kresol-Novolak (HRJ 2606, Hersteller Schenectady) werden zusammen mit 0,75 g Tetramethoxymethylglucoril der Formel 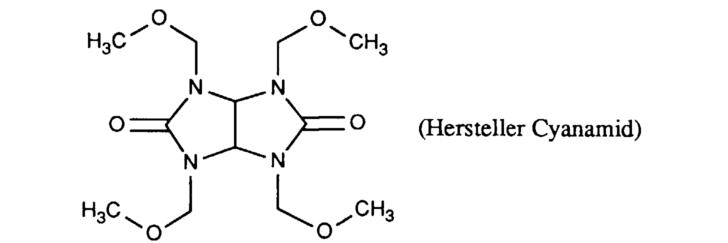 und 0,12 g α-(4-Toluol-sulfonyloxyimino)-4-methoxybenzylcyanid in 15 g 1-Methoxy-2-propylacetat gelöst und mit einem 0,2 µm Filter filtriert. Die Resistlösung wird so auf einen Siliciumwafer aufgeschleudert, dass nach der Vortrocknung auf einer Hotplate ein Film mit einer Schichtdicke von 1,2 µm resultiert. Nach einer mit 50 mJ/cm² analog zu Beispiel 2 durchgeführten Belichtung, 60-sekündigem Ausheizen bei 120 °C auf der Hotplate und anschliessendem Entwickeln in wässeriger 0,262 N TMAH Loesung wird ein negatives Abbild der Strukturierungsmaske, wobei Submikrometerstrukturen ebenfalls gut aufgelöst werden. Die Profilkanten der gebildeten Strukturen sind senkrecht.

## Patentansprüche

1. Verwendung von Oximsulfonatverbindungen der Formel 1 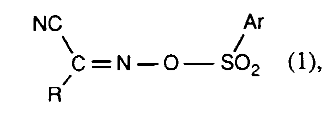 worin
R Naphthyl, 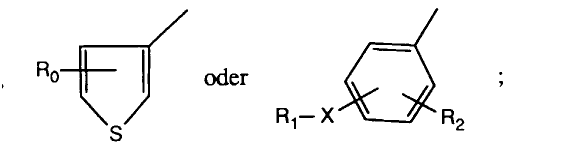 Ar eine unsubstituierte Arylgruppe oder eine Arylgruppe darstellt, die einen oder mehrere Substituenten, ausgewählt aus Nitro-, Chlor-, Brom-, Hydroxyl-, C₁-C₄-Alkyl-, C₁-C₄-Perfluoralkyl-, C₁-C₄-Alkyloxy- und säurespaltbaren Substituenten, aufweist;
R₀ entweder eine R₁-X-Gruppe oder R₂;
X ein Sauerstoff- oder Schwefelatom;
R₁ Wasserstoff, C₁-C₄-Alkyl oder eine unsubstituierte oder eine einen Substituenten, ausgewählt aus Chlor-, Brom-, C₁-C₄-Alkyl-, C₁-C₄-Alkyloxysubstituenten, aufweisende Phenylgruppe und
R₂ Wasserstoff, C₁-C₄-Alkyl oder einen säurespaltbaren Substituenten bedeuten,
als strahlungsempfindlicher Säurespender in einem chemisch verstärkten alkalisch entwickelbaren Photoresist für Strahlung einer Wellenlänge von 340 bis 390 Nanometern.

2. Chemisch verstärkter, alkalisch entwickelbarer und positiv arbeitender Photoresist für Strahlung einer Wellenlänge von 340 bis 390 Nanometern auf Basis von Oximsulfonaten als strahlungsempfindlichem Säurespender, wobei der Photoresist als Oximsulfonat eine Verbindung der Formel 1 enthält 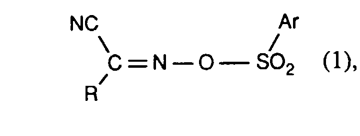 worin
R Naphthyl, 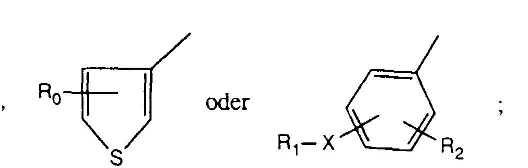 Ar eine unsubstituierte Arylgruppe oder eine Arylgruppe darstellt, die einen oder mehrere Substituenten, ausgewählt aus Nitro-, Chlor-, Brom-, Hydroxyl-, C₁-C₄-Alkyl-, C₁-C₄-Perfluoralkyl-, C₁-C₄-Alkyloxy- und säurespaltbaren Substituenten, aufweist;
R₀ entweder eine R₁-X-Gruppe oder R₂;
X ein Sauerstoff- oder Schwefelatom;
R₁ Wasserstoff, C₁-C₄-Alkyl oder eine unsubstituierte oder eine einen Substituenten, ausgewählt aus Chlor-, Brom-, C₁-C₄-Alkyl-, C₁-C₄-Alkyloxysubstituenten, aufweisende Phenylgruppe und
R₂ Wasserstoff, C₁-C₄-Alkyl oder einen säurespaltbaren Substituenten bedeuten.

3. Chemisch verstärkter, alkalisch entwickelbarer und negativ arbeitender Photoresist für Strahlung einer Wellenlänge von 340 bis 390 Nanometern auf Basis von Oximsulfonaten als strahlungsempfindlichem Säurespender, wobei der Photoresist als Oximsulfonat eine Verbindung der Formel 1 enthält 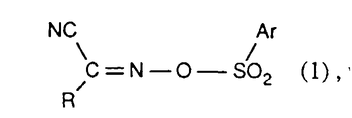 worin
R Naphthyl, 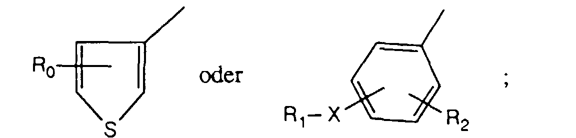 Ar eine unsubstituierte Arylgruppe oder eine Arylgruppe darstellt, die einen oder mehrere Substituenten, ausgewählt aus Nitro-, Chlor-, Brom-, Hydroxyl-, C₁-C₄-Alkyl-, C₁-C₄-Perfluoralkyl- oder Methoxy-, Ethoxy-, n-Propyloxy- oder n-Butyloxy substituenten, aufweist;
R₀ entweder R₁-X-Gruppe oder R₂;
X ein Sauerstoff- oder Schwefelatom;
R₁ Wasserstoff, Methyl, Ethyl, n-Propyl, n-Butyl oder eine unsubstituierte oder eine einen Substituenten, ausgewählt aus Chlor-, Brom-, C₁-C₄-Alkyl-, Methoxy-, Ethoxy-, n-Propyloxy- oder n-Butyloxy substituenten, ausweisende Phenylgruppe und
R₂ Wasserstoff oder C₁-C₄-Alkyl bedeuten.

4. Photoresist gemäss einem der Ansprüche 2 oder 3, der eine Verbindung der Formel 1 enthält, worin R 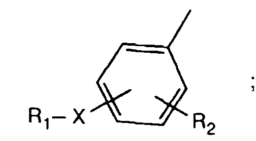 Ar eine Arylgruppe der Formel 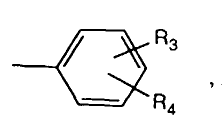 X ein Sauerstoffatom, R₁ einen C₁-C₄-Alkyl- oder Phenylrest und
R₂, R₃ und R₄ unabhängig voneinander Wasserstoff, Chlor oder Methyl bedeuten.

5. Photoresist gemäss einem der Ansprüche 2 oder 3, der eine Verbindungen der Formel 1 enthält, worin R 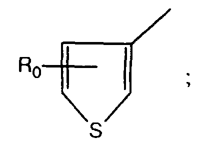 Ar eine Arylgruppe der Formel 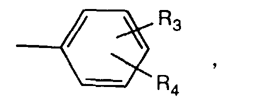 wobei R₃ und R₄ unabhängig voneinander Wasserstoff, Chlor oder Methyl und R₀ Wasserstoff bedeuten.

6. Negativ arbeitender Photoresist gemäss einem der Ansprüche 3 bis 5, enthaltend ein Oximsulfonat der Formel 1, das keine säurespaltbaren Substituenten aufweist, ein alkalilösliches Phenolharz als Bindemittel und eine Komponente, die säurekatalysiert eine Vernetzungsreaktion mit sich selbst und/oder dem Bindemittel eingeht.

7. Negativresist gemäss Anspruch 6, enthaltend 1 bis 15 Gewichtsprozent des Oximsulfonats, 40 bis 80 Gewichtsprozent eines Phenolharzes als Bindemittel sowie 5 bis 30 Gewichtsprozent eines Aminoharzes als Vernetzungsmittel, wobei sich die Prozentangaben auf den Feststoffgehalt der Zusammensetzung beziehen.

8. Negativresist gemäss Anspruch 7, enthaltend N-Methoxymethylmelamin oder Tetramethoxymethylglucoril und N,N'-Dimethoxymethyluron in hochreiner oder technischer Form als Aminoharz.

9. Positiv arbeitender Photoresist gemäss einem der Ansprüche 2, 4 oder 5, enthaltend eine Verbindung der Formel 1, die jedoch keine säurespaltbaren Substituenten aufweist, und mindestens eine Verbindung, die das Lösen der Zusammensetzung in einem alkalischen Entwickler im wesentlichen verhindert, die aber in Gegenwart von Säure in einer Weise gespalten werden kann, dass Reaktionsprodukte verbleiben, die in dem Entwickler löslich sind und/oder die Lösung eines sonst im Entwickler praktisch unlöslichen, säureresistenten zusätzlich enthaltenen Bindemittels im Entwickler bewirken.

10. Positivresist gemäss Anspruch 9, enthaltend 75 bis 99,5 Gewichtsprozent eines filmbildenden Polymeren, der säurekatalysiert abspaltbare Schutzgruppen aufweist, und 0,5 bis 25 Gewichtsprozent Oximsulfonate der Formel 1, wobei die Prozentangaben auf den Feststoffgehalt der Zusammensetzungen bezogen sind.

11. Positivresist gemäss Anspruch 9, enthaltend 40 bis 90 Gewichtsprozent eines säureinerten filmbildenden Polymeren als Bindemittel, 5 bis 40 Gewichtsprozent einer monomeren oder polymeren Verbindung, die säurekatalysiert abspaltbare Schutzgruppen aufweist, und 0,5 bis 25 Gewichtsprozent Oximsulfonate der Formel 1, wobei die Prozentangaben auf den Feststoffgehalt der Zusammensetzungen bezogen sind.

12. Positiv arbeitender Photoresist gemäss einem der Ansprüche 2, 4 oder 5, enthaltend eine Verbindung der Formel 1, die mindestens einen säurespaltbaren Substituenten aufweist und ein in einem alkalischen Entwickler praktisch unlösliches Bindemittel, das in Gegenwart der Reaktionsprodukte, die bei Säurespaltung der genannten säurespaltbaren Substituenten entstehen, im Entwickler löslich wird.

13. Verfahren zur Herstellung von Abbildungen, bei der ein Substrat mit einer Zusammensetzung gemäss einem der Ansprüche 2 bis 12 beschichtet wird, die Beschichtung mit Strahlung einer Wellenlänge von 340 bis 390 Nanometern in einem gewünschten Muster bestrahlt wird und nach einer Erwärmungsphase die besser löslichen Partien der Beschichtung mit einem alkalischen Entwickler entfernt werden.

## Claims

1. The use of an oxime sulfonate compound of formula 1 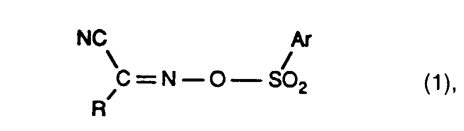 wherein
R is naphthyl, 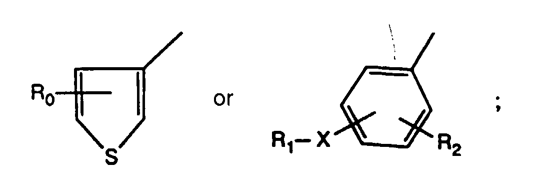
Ar is an unsubstituted aryl group or an aryl group which carries one or more than one substituent selected from the group consisting of nitro, chloro, bromo, hydroxyl, C₁-C₄alkyl, C₁-C₄perfluoroalkyl, C₁-C₄alkoxy and acid-cleavable substituents;
R₀ is either a R₁-X group or R₂;
X is an oxygen or a sulfur atom;
R₁ is hydrogen, C₁-C₄alkyl or unsubstituted phenyl or phenyl which carries a substituent selected from the group consisting of chloro, bromo, C₁-C₄alkyl and C₁-C₄alkoxy, and
R₂ is hydrogen, C₁-C₄alkyl or an acid-cleavable substituent,
as a radiation-sensitive acid generator in a chemically amplified photoresist which is developable in alkaline medium and is sensitive to radiation of a wavelength from 340 to 390 nanometers.

2. A chemically amplified, positive-working photoresist which is developable in alkaline medium and is sensitive to radiation of a wavelength from 340 to 390 nanometers and is based on an oxime sulfonate as radiation-sensitive acid generator, which photoresist contains as oxime sulfonate a compound of formula 1 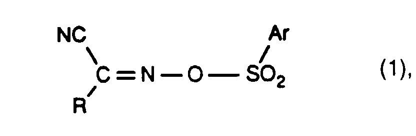 wherein
R is naphthyl, 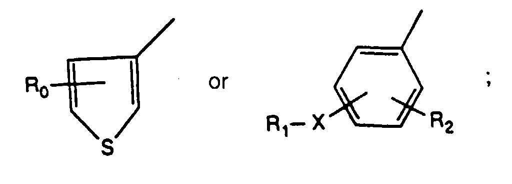
Ar is an unsubstituted aryl group or an aryl group which carries one or more than one substituent selected from the group consisting of nitro, chloro, bromo, hydroxyl, C₁-C₄alkyl, C₁-C₄perfluoroalkyl, C₁-C₄alkoxy and acid-cleavable substituents;
R₀ is either a R₁-X group or R₂;
X is an oxygen or a sulfur atom;
R₁ is hydrogen, C₁-C₄alkyl or unsubstituted phenyl or phenyl which carries a substituent selected from the group consisting of chloro, bromo, C₁-C₄alkyl and C₁-C₄alkoxy, and
R₂ is hydrogen, C₁-C₄alkyl or an acid-cleavable substituent.

3. A chemically amplified, negative-working photoresist which is developable in alkaline medium and is sensitive to radiation of a wavelength from 340 to 390 nanometers and is based on an oxime sulfonate as radiation-sensitive acid generator, which photoresist contains as oxime sulfonate a compound of formula 1 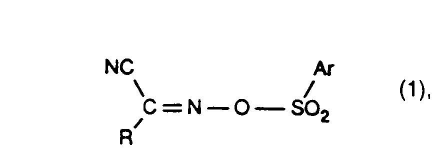 wherein
R is naphthyl, 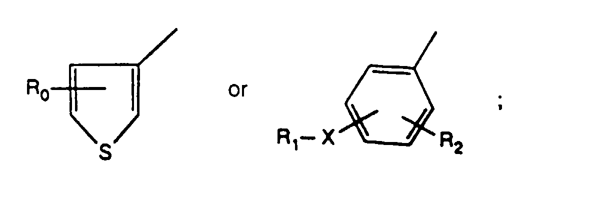
Ar is an unsubstituted aryl group or an aryl group which carries one or more than one substituent selected from the group consisting of nitro, chloro, bromo, hydroxyl, C₁-C₄alkyl, C₁-C₄perfluoroalkyl or methoxy, ethoxy, n-propyloxy or n-butyloxy,
R₀ is either a R₁-X group or R₂;
X is an oxygen or a sulfur atom;
R₁ is hydrogen, methyl, ethyl, n-propyl, n-butyl or unsubstituted phenyl or phenyl which carries a substituent selected from the group consisting of chloro, bromo, C₁-C₄alkyl and methoxy, ethoxy, n-propyloxy or n-butyloxy, and
R₂ is hydrogen or C₁-C₄alkyl.

4. A photoresist according to one of claims 2 and 3, which comprises a compound of formula 1 wherein R is 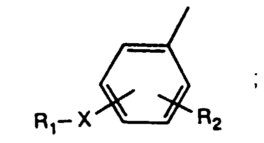 Ar is an aryl group of formula, 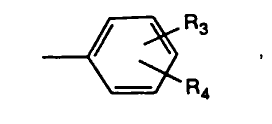 X is an oxygen atom, R₁ is C₁-C₄alkyl or phenyl, and R₂, R₃ and R₄ each independently of one another are hydrogen, chloro or methyl.

5. A photoresist according to one of claims 2 and 3, which comprises a compound of formula 1 wherein R is 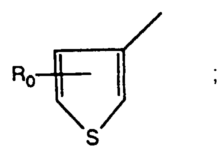 Ar is an aryl group of formula 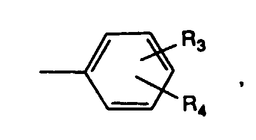 R₃ and R₄ each independently of one another are hydrogen, chloro or methyl, and R₀ is hydrogen.

6. A negative-working photoresist according to one of claims 3 to 5, comprising an oxime sulfonate of formula 1 that does not contain any acid-cleavable substituents, an alkali-soluble phenolic resin binder, and a component which, when acid-catalysed, undergoes a crosslinking reaction with itself and/or with the binder.

7. A negative resist according to claim 6, comprising 1 to 15% by weight of the oxime sulfonate, 40 to 80% by weight of a phenolic resin binder, and 5 to 30% by weight of an amino resin crosslinking agent, the percentages being based on the solids content of the composition.

8. A negative resist according to claim 7, comprising N-methoxymethylmelamine or tetramethoxymethylglucoril and N,N'-dimethoxymethyluron in high-purity or technical form as amino resin.

9. A positive-working photoresist according to one of claims 2, 4 and 5, comprising a compound of formula 1 that does not contain any acid-cleavable substituents, and at least one compound which substantially prevents the dissolution of the composition in an alkaline developer but which, in the presence of acid, can be cleaved to leave reaction products that are soluble in the developer and/or induce the dissolution in the developer of an acid-resistant binder which is additionally present and is otherwise virtually insoluble in the developer.

10. A positive resist according to claim 9, comprising 75 to 99.5% by weight of a film-forming polymer having protective groups eliminable under acid catalysis, and 0.5 to 25% by weight of oxime sulfonates of formula 1, the percentages being based on the solids content of the composition.

11. A positive resist according to claim 9, comprising 40 to 90% by weight of an acid-inert film-forming polymer binder, 5 to 40% by weight of a monomeric or polymeric compound having protective groups eliminable under acid catalysis, and 0.5 to 25% by weight of oxime sulfonate of formula 1, the percentages being based on the solids content of the composition.

12. A positive-working photoresist according to one of claims 2, 4 and 5, comprising a compound of formula 1 which carries at least one acid-cleavable substituent, and a binder that is virtually insoluble in an alkaline developer and which, in the presence of reaction products that are formed upon acid cleavage of the said acid-cleavable substituents, becomes soluble in the developer.

13. A process for the production of an image, which comprises coating a substrate with a composition according to one of claims 2 to 12, irradiating the coating to radiation of a wavelength from 340 to 390 nanometers in a desired pattern and, after a heating phase, removing the more readily soluble portions of the coating with an alkaline developer.

## Revendications

1. Utilisation des composés de sulfonates d'oxime de formule 1 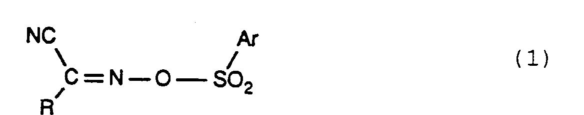 dans laquelle R représente le groupe naphtyle, 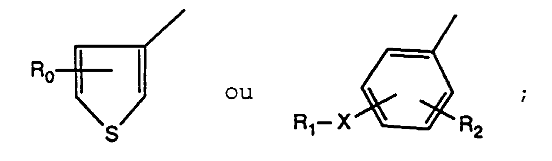
Ar représente un groupe aryle non substitué ou un groupe aryle qui présente un ou plusieurs substituants pris dans le groupe comportant des groupes nitro, chloro, bromo, hydroxyle, alkyle en C₁-C₄, perfluoralkyle en C₁-C₄, alkyloxy en C₁-c₄ et des substituants dissociables par un acide ;
R₀ représente soit un groupe R₁-X, soit R₂ ;
X représente un atome d'oxygène ou de soufre ;
R₁ représente un atome d'hydrogène, un groupe alkyle en C₁-C₄ ou un groupe phényle non substitué ou présentant un substituant pris parmi les groupes chloro, bromo, alkyle en C₁-C₄, alkoxy en C₁-C₄, et
R₂ représente un atome d'hydrogène, un groupe alkyle en C₁-C₄ ou un substituant dissociables à l'acide,
en tant que donneur d'acide sensible au rayonnement dans un photorésist chimiquement renforcés, développable en milieu alcalin, pour un rayonnement d'une longueur d'onde de 340 à 390 nanomètres.

2. Photorésist chimiquement renforcé, développable en milieu alcalin et positif pour un rayonnement d'une longueur d'onde de 340 à 390 nanomètres à base de sulfonates d'oxime en tant que donneur d'acide sensible au rayonnement, le photorésist contenant en tant que sulfonate d'oxime un composé de formule 1 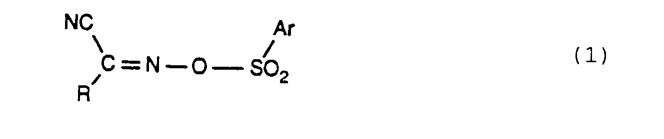 dans laquelle R représente le groupe naphtyle, 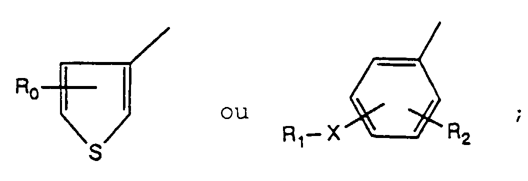
Ar représente un groupe aryle non substitué ou un groupe aryle qui présente un ou plusieurs substituants pris dans le groupe comportant des groupes nitro, chloro, bromo, hydroxyle, alkyle en C₁-C₄, perfluoralkyle en C₁-C₄, alkyloxy en C₁-C₄ et des substituants dissociables par un acide ;
R₀ représente soit un groupe R₁-X soit R₂ ;
X représente un atome d'oxygène ou de soufre ;
R₁ représente un atome d'hydrogène, un groupe alkyle en C₁-C₄ ou un groupe phényle non substitué ou présentant un substituant pris parmi les groupes chloro, bromo, alkyle en C₁-C₄, alkoxy en C₁-C₄, et
R₂ représente un atome d'hydrogène, un groupe alkyle en C₁-C₄ ou un substituant dissociables à l'acide.

3. Photorésist chimiquement renforcé, développable en milieu alcalin et positif pour un rayonnement d'une longueur d'onde de 340 à 390 nanomètres à base de sulfonates d'oxime en tant que donneur d'acide sensible au rayonnement, le photorésist contenant en tant que sulfonate d'oxime un composé de formule 1 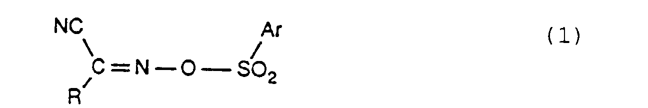 dans laquelle
R représente le groupe naphtyle, 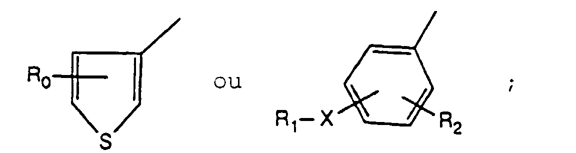
Ar représente un groupe aryle non substitué ou un groupe aryle qui présente un ou plusieurs substituants pris dans le groupe comportant des groupes nitro, chloro, bromo, hydroxyle, alkyle en C₁-C₄, perfluoralkyle en C₁-C₄ ou méthoxy, éthoxy, n-propyloxy ou n-butyloxy ;
R₀ représente soit un groupe R₁-X, soit R₂ ;
X représente un atome d'oxygène ou de soufre ;
R₁ représente un atome d'hydrogène, des groupes méthyle, éthyle, n-propyle, n-butyle ou un groupe phényle non substitué ou présentant un substituant pris parmi les substituants chloro, bromo, alkyle en C₁-C₄, méthoxy, éthoxy, n-propyloxy ou n-butyloxy et
R₂ représente un atome d'hydrogène, un groupe alkyle en C₁-C₄.

4. Photorésist selon l'une des revendications 2 ou 3, qui contient un composé de formule 1, dans laquelle R représente 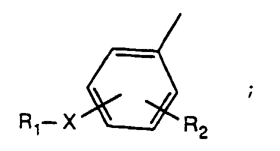 Ar représente un groupe aryle de formule 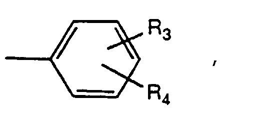 X représente un atome d'oxygène, R₁ représente un reste alkyle en C₁-C₄ ou phényle et R₂, R₃ et R₄, indépendamment les uns des autres, représentent un atome d'hydrogène, de chlore ou un groupe méthyle.

5. Photorésist selon l'une des revendications 2 ou 3, qui contient un composé de formule 1, dans lequel R représente 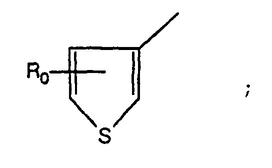 Ar représente un groupe aryle de formule 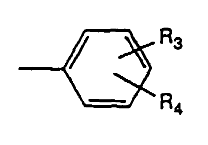 R₃ et R₄, indépendamment l'un de l'autre, représentent un atome d'hydrogène, de chlore ou un groupe méthyle et R₀ représente un atome d'hydrogène.

6. Photorésist négatif selon l'une des revendications 3 à 5, contenant un sulfonate d'oxime de formule 1, qui ne présente pas de substituants dissociables par un acide, une résine phénolique soluble en milieu alcalin en tant que liant et un composant qui réagit avec soi-même et/ou le liant dans une réaction de réticulation catalysée par un acide.

7. Résist négatif selon la revendication 6, contenant de 1 à 15 % en poids de sulfonate d'oxime de 40 à 80 % en poids d'une résine phénolique en tant que liant ainsi que de 5 à 30 % en poids d'une résine aminée en tant que réticulant, les données en pourcentage étant relatives à la teneur en extrait sec de la composition.

8. Résist négatif selon la revendication 7, contenant de la N-méthoxyméthylmélamine ou du tétraméthoxyméthylglucorile et de la N,N'-diméthoxyméthylurone sous forme très pure ou technique en tant que résine aminée.

9. Résist positif selon l'une des revendication 2, 4 ou 5, contenant un composé de formule 1, mais qui ne présente pas de substituants dissociables par un acide, et au moins un composé qui empêche essentiellement la dissolution de la composition dans un révélateur alcalin, mais que l'on peut dissocier en présence d'un acide de façon telle qu'il se forme des produits de réaction lesquels sont solubles dans le révélateur et/ou provoquent la dissolution d'un liant résistant à l'acide par ailleurs pratiquement insoluble dans le révélateur, liant contenu en plus dans le révélateur.

10. Résist positif selon la revendication 9, contenant de 75 à 99,5 % en poids d'un polymère filmogène, qui présente des groupes protecteurs dissociables par un acide, et de 0,5 à 25 % en poids de sulfonates d'oxime de formule 1, les données en pourcentages étant relatives à la teneur en extrait sec de la composition.

11. Résist positif selon la revendication 9, contenant, en tant que liant, de 40 à 90 % en poids d'un polymère filmogène inerte à l'acide, de 5 à 40 % en poids d'un composé monomère ou polymère qui présente des groupes protecteurs dissociables sous catalyse acide, et de 0,5 à 25 % en poids de sulfonates d'oxime de formule 1, les données en pourcentage étant relatives à la teneur en extrais sec de la composition.

12. Résist positif selon l'une des revendications 2, 4 ou 5, contenant un composé de formule 1, qui présente au moins un substituant dissociables par un acide et un liant pratiquement insoluble dans un révélateur alcalin, lequel devient soluble dans le révélateur en présence de produits de réaction qui se forment au cours de la dissociation par un acide des substituants dissociables par un acide.

13. Procédé pour la préparation de reproductions dans lequel on revêt un substrat par une composition selon l'une des revendications 2 à 12, on irradie le revêtement par un rayonnement d'une longueur d'onde de 340 à 390 nanomètres selon un modèle voulu et après une phase de réchauffage, on élimine dans un révélateur alcalin les parties du revêtement ayant une meilleure solubilité.
